(19) Europäisches Patentamt
European Patent Office
Office européen des brevets

(11) **EP 2 543 134 B1**

(12) **FASCICULE DE BREVET EUROPEEN**

(45) Date de publication et mention
de la délivrance du brevet:
**24.01.2018 Bulletin 2018/04**

(21) Numéro de dépôt: **11705612.7**

(22) Date de dépôt: **01.03.2011**

(51) Int Cl.:
**H03B 15/00** *(2006.01)*

(86) Numéro de dépôt international:
**PCT/EP2011/053027**

(87) Numéro de publication internationale:
**WO 2011/107475 (09.09.2011 Gazette 2011/36)**

(54) **OSCILLATEUR RADIOFREQUENCE MAGNETORESISTIF ET PROCEDE DE GENERATION D'UN SIGNAL OSCILLANT**

MAGNETORESISTIVER HF-OSZILLATOR UND VERFAHREN ZUR ERZEUGUNG EINES SCHWINGUGNSSIGNALS

MAGNETORESISTIVE RADIOFREQUENCY OSCILLATOR AND METHOD FOR GENERATING AN OSCILLATING SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.03.2010 FR 1051544**

(43) Date de publication de la demande:
**09.01.2013 Bulletin 2013/02**

(73) Titulaires:
• **Commissariat à l'Énergie Atomique et aux Énergies Alternatives**
**75015 Paris (FR)**
• **Centre National de la Recherche Scientifique**
**75016 Paris (FR)**

(72) Inventeurs:
• **HOUSSAMEDDINE, Dimitri**
**38100 Grenoble (FR)**
• **QUINSAT, Michael**
**38000 Grenoble (FR)**
• **DELAET, Bertrand**
**38190 Bernin (FR)**
• **CYRILLE, Marie-Claire**
**38650 Sinard (FR)**
• **EBELS, Ursula**
**38100 Grenoble (FR)**

(74) Mandataire: **Colombo, Michel et al**
**Brevinnov**
**310 avenue Berthelot**
**69008 Lyon (FR)**

(56) Documents cités:
**EP-A1- 1 860 769     JP-A- 2008 128 711**
**US-B1- 6 566 872**

**Description**

L'invention concerne un oscillateur radiofréquence et un procédé de génération d'un signal oscillant avec cet oscillateur radiofréquence.

Des oscillateurs radiofréquences intègrent un dispositif magnétorésistif au sein duquel circule un courant électrique polarisé en spin. Dans un tel oscillateur, le passage du courant provoque une variation périodique de la résistance du dispositif magnétorésistif. Un signal haute fréquence, c'est-à-dire dont la fréquence est typiquement comprise entre 100 MHz et quelques dizaines de GHz, est construit à partir de cette variation périodique. La période des variations de la résistance, et donc la fréquence d'oscillation, peut être réglée en jouant sur l'intensité du courant qui traverse le dispositif magnétorésistif et/ ou un champ magnétique externe.

De tels oscillateurs ont par exemple vocation à être utilisés dans le domaine des radiotélécommunications car ils peuvent générer une large gamme de fréquences avec un facteur de qualité élevé.

Par facteur de qualité, on désigne ici le rapport suivant :

$$Q = f_{osc}/\Delta f$$

où :

- Q est le facteur de qualité,
- $f_{osc}$ est la fréquence d'oscillation de l'oscillateur, et
- $\Delta f$ est la largeur à mi-hauteur de la raie centrée sur la fréquence $f_{osc}$ dans le spectre de puissance de cet oscillateur.

Certains oscillateurs radiofréquences sont issus de l'électronique de spin.

L'électronique de spin utilise le spin des électrons comme degré de liberté supplémentaire afin de générer des effets nouveaux. La polarisation en spin d'un courant électrique résulte de l'asymétrie existant entre la diffusion des électrons de conduction de type "spin-up" (c'est-à-dire parallèle à l'aimantation locale) et de type "spin-down" (c'est-à-dire anti-parallèle à l'aimantation locale). Cette asymétrie conduit à une asymétrie de la conductivité entre les deux canaux de spin-up et down, d'où une polarisation de spin nette du courant électrique.

Cette polarisation en spin du courant est à l'origine de phénomènes magnétorésistifs dans les multicouches magnétiques tels que la magnétorésistance géante (Baibich, M., Broto, J.M., Fert, A., Nguyen Van Dau, F., Petroff, F., Etienne, P., Creuzet, G., Friederch, A. and Chazelas, J., " Giant magnetoresistance of (001)Fe/(001)Cr magnetic superlattices ", Phys.Rev.Lett., 61 (1988) 2472), ou la magnétorésistance tunnel (Moodera, JS., Kinder, LR., Wong, TM. and Meservey,R.. "Large magnetoresistance at room temperature in ferromagnetic thin film tunnel junctions", Phys.Rev.Lett 74 , (1995) 3273-6).

Par ailleurs, il a également été observé qu'en faisant passer un courant polarisé en spin à travers une couche mince magnétique, on pouvait induire un renversement de son aimantation en l'absence de tout champ magnétique externe (Katine, J.A., Albert, F.J., Buhrman, R.A., Myers, E.B., and Ralph, D.C., "Current-Driven Magnetization Reversai and Spin-Wave Excitations in Co /Cu /Co Pillars ", Phys.Rev.Lett. 84, 3149 (2000)).

Le courant polarisé peut également générer des excitations magnétiques entretenues, également dénommées oscillations (Kiselev, S.I., Sankey, J.C., Krivorotov, LN., Emley, N.C., Schoelkopf, R.J., Buhrman, R.A., and Ralph, D.C., "Microwave oscillations of a nanomagnet driven by a spin-polarized current", Nature, 425, 380 (2003)). L'utilisation de l'effet de génération d'excitations magnétiques entretenues dans un dispositif magnétorésistif permet de convertir cet effet en une modulation de résistance électrique directement utilisable dans les circuits électroniques, et donc corollairement, susceptible d'intervenir directement au niveau de la fréquence. Le document US 5 695 864 décrit divers développements mettant en oeuvre le principe physique mentionné précédemment. Il décrit notamment la précession de l'aimantation d'une couche magnétique traversée par un courant électrique polarisé en spin. Les principes physiques mis en oeuvre ainsi que la terminologie utilisée sont également décrits et définis dans la demande de brevet FR 2 892 871.

La fréquence d'oscillation de ces oscillateurs radiofréquences est ajustée en jouant sur l'intensité du courant qui le traverse et, éventuellement en plus, sur un champ magnétique externe.

Des oscillateurs radiofréquences connus comporte :

- un dispositif magnétorésistif au sein duquel circule un courant électrique polarisé en spin pour générer un signal oscillant à une fréquence d'oscillation sur une borne de sortie, ce dispositif comprenant un empilement d'au moins :

  • une première couche magnétique, dite « couche de référence », apte à polariser en spin le courant électrique et dont l'aimantation est de direction fixe,
  • une second couche magnétique, dite « couche libre », dont l'aimantation peut osciller lorsqu'elle est traversée par le courant polarisé en spin, et
  • une couche non magnétique, dite « espaceur », interposée entre les deux couches précédentes pour former une jonction tunnel ou une vanne de spin,

- une source de courant pour faire circuler un courant d'électrons dans lesdites couches perpendiculairement à celles-ci,

- une borne de commande de la fréquence ou de l'amplitude du signal oscillant,
- une boucle de rétroaction raccordée entre la borne de sortie et la borne de commande.

L'espaceur forme une jonction tunnel lorsque celui-ci est conçu pour créer le phénomène de magnétorésistance tunnel. En variante, l'espaceur forme une vanne de spin lorsque celui-ci est conçu pour créer le phénomène de magnétorésistance géante.

Les oscillateurs connus fonctionnent correctement mais plusieurs améliorations sont souhaitables. Par exemple, il est souhaitable d'améliorer le facteur de qualité de ces oscillateurs radiofréquences. Il est également souhaitable de réduire leur consommation électrique.

De l'état de la technique est connu de :

- JP2008128711 A,
- EP 1 860 769 A1,
- US 6 566 872 B1.

L'invention vise à améliorer les oscillateurs radiofréquences connus sur au moins l'un de ces points.

Elle a donc pour objet un oscillateur radiofréquence conforme à la revendication 1.

Ré-injecter une partie amplifiée du signal oscillant sur la borne de commande permet d'améliorer le facteur de qualité de l'oscillateur.

Les modes de réalisation de cet oscillateur peuvent comporter une ou plusieurs des caractéristiques des revendications dépendantes.

Ces modes de réalisation présentent en outre les avantages suivants :

- utiliser un dispositif magnétorésistif dont l'intensité du courant reste inférieure au courant critique permet de limiter la consommation de courant et d'utiliser des dispositifs magnétorésistifs plus sensibles ;
- utiliser une boucle de rétroaction directement raccordée entre la borne de sortie et la borne de commande permet d'obtenir une boucle de rétroaction très courte qui n'introduit quasiment aucun retard de phase et évite donc l'utilisation d'un déphaseur.
- utiliser un dispositif magnétorésistif dont le produit RA est supérieur à 2 ou à 5 $\Omega \mu m^2$ accroît l'amplitude du signal oscillant ;
- utiliser un champ magnétique pour commander la fréquence ou l'amplitude du signal oscillant décroît la consommation électrique de l'oscillateur.

L'invention a également pour objet un procédé de génération d'un signal oscillant à une fréquence d'oscillation conforme à la revendication 8.

Les modes de réalisation de ce procédé peuvent comporter la caractéristique de la revendication 9.

L'invention sera mieux comprise à la lecture de la description qui va suivre, donnée uniquement à titre d'exemple non limitatif et faite en se référant aux dessins sur lesquels :

- la figure 1 est une illustration schématique de l'architecture d'un oscillateur radiofréquence,
- la figure 2 est une illustration schématique et en coupe verticale d'un dispositif magnétorésistif utilisé dans l'oscillateur de la figure 1 ;
- la figure 3 est un organigramme d'un procédé de génération d'un signal oscillant à l'aide de l'oscillateur de la figure 1 ;
- les figures 4, 5 et 6 sont des illustrations schématiques de modes alternatifs de réalisation d'un oscillateur radiofréquence; et
- la figure 7 est une illustration schématique de l'architecture d'un autre dispositif magnétorésistif utilisable dans l'oscillateur de la figure 1.

Dans ces figures, les mêmes références sont utilisées pour désigner les mêmes éléments.

Dans la suite de cette description, les caractéristiques et fonctions bien connues de l'homme du métier ne sont pas décrites en détail.

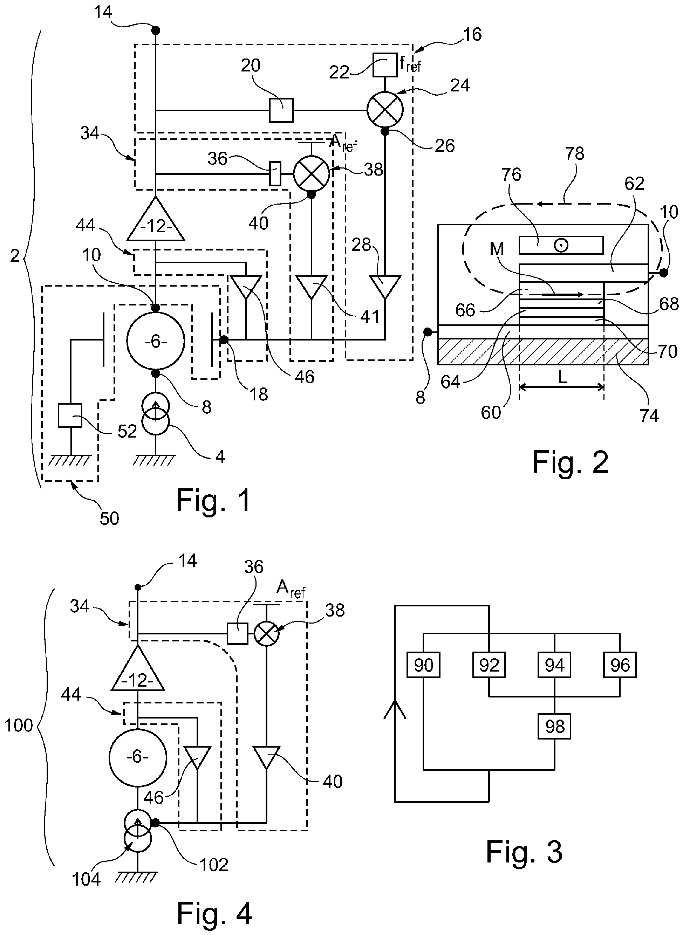

La figure 1 représente une architecture générale d'un oscillateur radiofréquence 2. Cet oscillateur 2 comporte :

- une source 4 de courant continu $I_d$,
- un dispositif 6 magnétorésistif équipé d'une borne d'entrée 8 raccordée à la source 4 de courant et d'une borne de sortie 10 du signal oscillant généré par ce dispositif 6, et
- un amplificateur 12 à faible bruit dont l'entrée est raccordée à la borne 10 et la sortie est raccordée à une borne 14 de sortie du signal oscillant généré par l'oscillateur 2.

Le dispositif 6 est formé d'un empilement de couches magnétiques et non magnétiques formant une jonction tunnel également connue sous l'acronyme de TMR (Tunnel MagnetoResistance). Cet empilement comporte au moins :

- une couche magnétique, dite « couche de référence », apte à polariser en spin le courant électrique généré par la source 4 et dont l'aimantation est de direction fixe,
- une couche magnétique, dite « couche libre », dont l'aimantation peut osciller lorsqu'elle est traversée par le courant polarisé en spin, et
- une couche non magnétique, dite « espaceur », interposée entre les deux couches précédentes pour créer la jonction tunnel.

Le dispositif 6 fonctionne comme un oscillateur à transfert de spin également connue sous l'acronyme STO (Spin Transfer Oscillator) lorsque l'intensité du courant polarisé en spin dépasse un seuil $I_c$ connu sous le terme de « courant critique d'oscillation ». Lorsque l'intensité du courant polarisé en spin dépasse ce seuil $I_c$, l'aimantation de la couche libre du dispositif 6 précesse de façon entretenue. Typiquement, le seuil $I_c$ correspond à une densité de courant supérieure à $10^7 A/cm^2$ dans la section transversale des couches de l'empilement. Dans le cas contraire, le dispositif 6 se comporte comme un résonateur, également désigné par l'acronyme STR (Spin Transfer Resonator), et le signal oscillant généré est amorti et non pas entretenu. Toutefois, même dans ce cas, pour générer le signal oscillant amorti, la densité de courant dans la section transversale des couches de l'empilement doit être élevée. Typiquement, par densité de courant « élevée » on désigne une densité de courant supérieure à $10^6 A/cm^2$.

Pour obtenir la densité de courant élevée, la section transversale d'au moins l'une des couches de l'empilement présente typiquement un diamètre inférieure à 300nm et, de préférence, inférieure à 200 ou 100nm. Lorsque la section transversale n'est pas un disque, le terme « diamètre » doit être compris comme signifiant « diamètre hydraulique ».

La source 4 génère un courant continu $I_d$ dont l'intensité est, dans ce mode de réalisation, inférieure au seuil $I_c$ mais suffisamment important pour engendrer une densité de courant élevée dans l'empilement des couches. Ainsi dans la suite de cette description, le dispositif 6 fonctionne comme un résonateur et non pas comme un oscillateur à transfert de spin.

L'oscillateur 2 comprend différentes boucles d'asservissement et de rétroaction. Pour simplifier la description, celles-ci sont toutes représentées dans le même mode de réalisation sur la figure 1. Toutefois, en pratique les boucles à mettre en oeuvre sont choisies en fonction des caractéristiques du dispositif 6.

Dans la figure 1, l'oscillateur 2 comprend une boucle 16 d'asservissement en fréquence du signal oscillant généré par le dispositif 6. Cette boucle 16 est également connue sous le terme de « boucle à verrouillage de phase » ou PLL (Phase Locked Loop). Cette boucle 16 est directement raccordée entre la borne 10 et une borne 18 de commande de la fréquence et de l'amplitude du signal oscillant $s(t)$ généré par le dispositif 6. Cette boucle 16 comprend un diviseur 20 de fréquence propre à générer à partir du signal oscillant $s(t)$ un signal oscillant $s(t)*$ de fréquence $f_{osc-r}$ plus réduite. Par exemple, le diviseur 20 divise par au moins 100 la fréquence $f_{osc}$ du signal $s(t)$. Ici, la fréquence $f_{osc-r}$ est comprise entre 1 et 100 MHz.

La boucle 16 comprend également une horloge 22 de référence qui génère un signal d'horloge $r(t)$, beaucoup plus stable que le signal oscillant $s(t)$, à une fréquence $f_{ref}$ très inférieure à la fréquence $f_{osc}$. La fréquence $f_{ref}$ est typiquement supérieure à 1 MHz et, par exemple, comprise entre 1 et 100 MHz.

Le diviseur 20 et l'horloge 22 sont raccordés à des entrées respectives d'un comparateur 24. Ce comparateur 24 génère un signal de commande $C_1(t)$ de la fréquence $f_{osc}$ sur une sortie 26. Ce signal $C_1(t)$ est construit de manière à réduire l'écart entre les fréquences $f_{osc-r}$ et $f_{ref}$.

La boucle 16 comprend également un amplificateur 28 propre à amplifier le signal $C_1(t)$ avant de l'injecter sur la borne 18 de commande.

L'oscillateur 2 comprend aussi une boucle 34 d'asservissement de l'amplitude $A_{osc}$ du signal oscillant $s(t)$ sur une valeur de référence $A_{ref}$ pour l'amplitude. A cet effet, la boucle 34 comprend un capteur 36 qui mesure l'amplitude $A_{osc}$. Cette mesure de l'amplitude $A_{osc}$ est ensuite transmise à un comparateur 38 de l'amplitude mesurée avec la valeur $A_{ref}$. Le comparateur 38 est très rapide et très précis. Par exemple, la précision du comparateur 38 est inférieure à 10 $\mu V$. Un tel comparateur est par exemple réalisé à l'aide de transistors intégrés aux couches du dispositif magnétorésistif 6.

Ce comparateur génère, sur une borne 40, un signal de commande $C_2(t)$ qui asservit l'amplitude $A_{osc}$ sur la valeur $A_{ref}$. Ce signal $C_2(t)$ est établi à partir de l'écart entre l'amplitude $A_{osc}$ et la valeur $A_{ref}$.

Le signal $C_2(t)$ est injecté sur la borne 18 après avoir été amplifié par un amplificateur 41.

Enfin, l'oscillateur 2 comprend également une boucle 44 de rétroaction pour injecter sur la borne 18 un signal de commande $C_3(t)$ permettant de transformer les oscillations amorties du dispositif 6 en oscillations entretenues même si l'intensité du courant $I_d$ est inférieure au seuil $I_c$. Pour cela, le signal $C_3(t)$ est un signal périodique amplifié injecté sur la borne 18 en phase avec le signal généré $s(t)$ au même instant sur la borne 10. Par « en phase » on désigne le fait que le déphasage entre les signaux $C_3(t)$ et $s(t)$ est égal à zéro ou pratiquement égal à zéro. Par exemple, ce déphasage est inférieur à $\pi/20$ rad. Ici, le signal $C_3(t)$ est une copie amplifiée du signal $s(t)$ généré par le dispositif 6.

La boucle 44 comprend également un amplificateur 46. Dans ce mode de réalisation, une entrée de l'amplificateur 46 est directement raccordée à la borne 10 sans passer par l'amplificateur 12 et une sortie de l'amplificateur est directement raccordée à la borne 18. Le gain de cet amplificateur est déterminé pour compenser les pertes du dispositif 6 et obtenir ainsi une oscillation entretenue même si l'intensité du courant $I_d$ est inférieure au seuil $I_c$. Ici, le gain de l'amplificateur 46 est déterminé expérimentalement. Pour cela, les pertes du dispositif 6 sont d'abord déterminées expérimentalement puis un gain permettant de compenser ces pertes est fixé pour l'amplificateur 46.

L'amplificateur 46 présente une bande passante située autour de la fréquence $f_{osc}$.

Pour que les signaux $s(t)$ et $C_3(t)$ soit en phase, la boucle 44 est la plus courte possible. Par exemple, sa longueur est inférieure à 10 mm et, de préférence, inférieures à 1 mm ou 100$\mu m$.

Pour régler l'amplitude et la fréquence du signal $s(t)$ généré par le dispositif 6, l'oscillateur 2 est équipé d'un générateur 50 de champ magnétique. Ce générateur 50 est agencé par rapport au dispositif 6 de manière à ce que les lignes du champ magnétique qu'il génère traversent la couche libre du dispositif 6.

Par exemple, ce générateur 50 se présente sous la forme d'une piste conductrice placée à proximité de l'empilement des couches du dispositif 6. La distance la plus courte qui sépare cette piste conductrice de la couche libre est inférieure à 100 μm pour limiter la consommation électrique du générateur 50. Avantageusement, cette distance sera inférieure à 10μm (piste intégrée) voire à 1 μm. Sur la figure 1, la résistivité de cette piste est représentée par une résistance 52. Par exemple, la valeur de résistance 52 est égale à 10 Ω et correspond à la résistance de la piste conductrice entre la borne 18 et un potentiel de référence tel que la masse.

Ce générateur 50 présente une borne permettant de faire varier l'intensité du champ magnétique généré. Ici, cette borne constitue la borne 18. En effet, une variation de l'intensité du champ magnétique qui traverse la couche libre permet de modifier l'amplitude et la fréquence du signal oscillant généré par le dispositif 6.

De préférence, la borne 18 est utilisée lorsque le dispositif 6 est faiblement accordable en fréquence à l'aide de l'intensité du courant polarisé en spin, voire très faiblement accordable. Par « faiblement accordable et très faiblement accordable » on désigne un dispositif magnétorésistif dont la dérivée, notée $df_{osc}/dI$, de la fréquence $f_{osc}$ en fonction de l'intensité I du courant polarisé en spin est strictement inférieure, respectivement, à 1 GHz/mA et 100MHz/mA sur la plage de fonctionnement de ce dispositif. Les dispositifs magnétorésistifs faiblement accordables sont généralement des structures planaires faciles à réaliser. Les structures planaires sont des structures dans lesquelles le moment magnétique des couches de référence et/ou libre est compris dans le plan de ces couches. Dans ces conditions, le dispositif magnétorésistif est généralement faiblement non linéaire. Par « faiblement non linéaire » on désigne le fait que la dérivée, notée $df_{osc}/dA$, de la fréquence $f_{osc}$ en fonction de l'amplitude A des variations de la résistance du dispositif 6 est inférieure à 10 MHz/Ω sur la plage de fonctionnement.

De préférence, la boucle 34 est uniquement utilisée si le dispositif 6 est fortement non-linéaire, c'est-à-dire que la dérivée $df_{osc}/dA$ est supérieure à 10 MHz/Ω et, de préférence, supérieure à 100 MHz/Ω sur la plage de fonctionnement de l'oscillateur. On notera que lorsqu'un dispositif magnétorésistif est fortement non-linéaire, il est généralement également fortement accordable de sorte qu'il n'est pas nécessaire d'utiliser le générateur 50 pour cet asservissement.

La boucle 34 est typiquement utilisée pour corriger des fluctuations de fréquence rapides (c'est-à-dire de durée inférieure à 1 μs) et la boucle 16 pour corriger les fluctuations lentes (c'est-à-dire de durée supérieure à 1 μs).

Généralement sur la plage de fonctionnement du dispositif 6, les variations de la fréquence $f_{osc}$ en fonction de l'intensité I ou de l'amplitude A sont linéaires ou susceptibles d'être approximées par une relation linéaire. Dans ces conditions, les dérivées $df_{osc}/dI$ et $df_{osc}/dA$ sont considérées comme constantes dans la suite de cette description.

La figure 2 représente un exemple de réalisation du dispositif magnétorésistif 6 et du générateur 50.

Ce dispositif magnétorésistif 6 est conformé selon une géométrie connue sous l'acronyme CPP (« current perpendicular to plane »). Plus précisément, sur la figure 2, le dispositif magnétorésistif adopte une structure connue sous le terme de « nanopilier ». Ce nanopilier est un pilier formé en empilant les unes au-dessus des autres des couches horizontales de même section horizontale.

De plus, le dispositif 6 comprend à chaque extrémité du pilier une électrode conductrice, respectivement, 60 et 62. Ces électrodes 60, 62 permettent d'amener le courant qui traverse les différentes couches formant le dispositif magnétorésistif perpendiculairement au plan de ces couches. Les extrémités libres de ces électrodes 60, 62 forment, respectivement, les bornes 8 et 10 du dispositif 6.

Lorsque l'intensité de ce courant dépasse l'intensité du courant critique $I_c$, la tension entre ces électrodes 60, 62 se met à osciller à la fréquence $f_{osc}$. Cette fréquence $f_{osc}$ est fonction de l'intensité du courant qui traverse les électrodes 60, 62. Par exemple, cette tension est transmise à un équipement électronique (non représenté) qui la traite pour créer un signal de référence.

Entre ces électrodes 60 et 62, le pilier comprend principalement trois couches à savoir une couche de référence 64, une couche libre 66 et une couche 68 non magnétique interposée entre les couches 64 et 66. La couche non magnétique est l'« espaceur » ou « spacer » en anglais.

Ces couches 64, 66 et 68 sont agencées et conformées de manière à permettre l'apparition des propriétés magnétoresistives, c'est-à-dire une variation de la résistance du pilier en fonction des directions d'aimantation des couches 64 et 66.

Pour améliorer la lisibilité de la figure 1, la proportionnalité entre l'épaisseur des différentes couches n'a pas été préservée.

La largeur L des différentes couches qui composent le pilier est constante. Ici, la largeur L est inférieure à 1 μm et, typiquement, comprise entre 20 nm et 200 nm.

La couche de référence 64 est réalisée dans un matériau magnétique électriquement conducteur. Sa face supérieure est directement en contact avec l'espaceur 68. Elle présente une direction de plus facile aimantation comprise dans le plan de la couche.

La couche de référence 64 a pour fonction de polariser en spin les électrons du courant qui la traverse. Elle présente donc une épaisseur suffisante pour réaliser cette fonction.

Par exemple, la couche de référence 64 est réalisée en cobalt (Co), Nickel (Ni), Fer(Fe) ou leur alliage (CoFe, NiFe, CoFeB ...etc.). L'épaisseur de la couche de référence 64 est de l'ordre de quelques nanomètres. La couche de référence 64 peut être laminée par insertion de quelques (typiquement de 2 à 4) très fines couches de cuivre, d'argent ou d'or d'épaisseur de l'ordre de 0,2 à 0,5 nm pour réduire la longueur de diffusion de spin. Il est possible également que la couche 64 soit un SyF (Synthetic Ferrimagnetic) voire un SAF (Synthetic Anti-Ferromagnetic).

Ici, la couche de référence 64 présente une aimantation dont la direction est fixe. Par aimantation de direction fixe, on désigne le fait que la direction du moment magnétique de la couche de référence 64 est plus difficile à modifier que la direction du moment magnétique de la couche libre 66. Pour obtenir cela, l'aimantation de la couche de référence 64 est par exemple piégée par une couche antiferromagnétique conductrice 70 interposée entre la couche de référence 64 et l'électrode 60. La face supérieure de la couche 70 est par exemple directement en contact avec la face inférieure de la couche de référence 64.

Typiquement, l'épaisseur de la couche 70 est comprise entre 5 et 50 nm. Elle peut être réalisée dans un alliage de manganèse tel que l'un des alliages suivants IrMn, PtMn, FeMn, ... etc. Par exemple, cette couche 70 est réalisée en un matériau choisi dans le groupe comprenant l'IrMn, le FeMn, le PtMn, NiMn.

L'espaceur 68 est une couche non magnétique. Cet espaceur 68 est suffisamment fin pour permettre au courant polarisé en spin de passer de la couche de référence 64 à la couche libre 66 en limitant la perte de polarisation. A l'inverse, l'épaisseur de cet espaceur 68 est suffisamment grande pour assurer le découplage magnétique entre les couches 64 et 66.

L'espaceur 68 est réalisé dans un matériau isolant tel qu'un oxyde ou un nitrure d'aluminium, un oxyde de magnésium, du nitrure de tantale, du titanate de strontium (SrTiO₃), ... etc. Le pilier présente alors des propriétés magnétorésistives tunnel ou TMR (Tunnel Magnetoresistance) et l'espaceur 68 forme une barrière tunnel. Dans ce cas, l'épaisseur de l'espaceur 68 est typiquement comprise entre 0,5 nm et 3 nm.

Ici, la barrière tunnel du dispositif 6 est épaisse pour présenter un facteur RA important, c'est-à-dire supérieur à 2 ou à 5 $\Omega\mu m^2$.

Le facteur RA d'une barrière tunnel est le produit de la résistance de la barrière tunnel avec son aire. Ici, l'aire est la superficie de la section transversale de la barrière tunnel.

Généralement, plus le facteur RA de la barrière tunnel est élevé plus la plage de variation de la résistivité de la jonction tunnel est élevé (par exemple supérieur à 10 %) et meilleure est la sensibilité de la jonction tunnel à la précession de l'aimantation dans la couche libre.

La couche libre 66 est une couche magnétique électriquement conductrice dont l'aimantation peut plus facilement tourner ou « précesser » que celle de la couche de référence 64..

De nombreux modes de réalisation de la couche libre sont possibles. Par exemple, des modes de réalisation possibles de cette couche libre sont décrits dans la demande de brevet déposée sous le numéro FR 0 957 888 et dans la demande de brevet publiée sous le numéro FR2 892 871.

La face inférieure de la couche 66 est directement en contact avec la face supérieure de l'espaceur 68. La face supérieure est quant à elle directement en contact avec l'électrode 62. Cette couche 66 est par exemple réalisée dans un matériau ferromagnétique tel que du cobalt, du nickel ou du fer ou dans un alliage de ces différents métaux (par exemple CoFe, CoFeB, NiFe, ... etc.).

En absence de courant polarisé en spin et de champ magnétique extérieur, la direction M du moment magnétique global de la couche 66 est orienté parallèlement au plan de cette couche. La direction M correspond alors à la direction de plus facile aimantation de la couche libre.

Typiquement, cet empilement de couches est réalisé sur la face supérieure d'un substrat 74.

Dans le mode particulier de réalisation représenté sur la figure 2 le générateur 50 est principalement constitué d'une piste conductrice 76 disposée par rapport à la couche 66 de manière à créer un champ magnétique dont les lignes de champ traversent cette couche 66. Un exemple de ligne de champ traversant la couche 66 est représenté par la ligne en pointillée 78 sur la figure 2. Par exemple, cette piste 76 est agencée par rapport à la couche 66 de manière à ce que les lignes de champ magnétique générées soient parallèles à la direction M de plus facile aimantation de la couche 66. Par exemple, ici, la piste 76 s'étend dans un plan parallèle au plan de la couche libre 66 et dans une direction perpendiculaire à la direction M. Ensuite, le courant traversant la piste 76 circule dans le sens approprié pour que le champ magnétique généré traverse la couche libre 66 dans la direction M de plus facile aimantation.

Pour minimiser l'intensité du courant électrique dans la piste 76 qui permet de générer un champ magnétique d'au moins 10 Oe dans la couche libre 66, cette piste 76 est fixée sans aucun degré de liberté à la couche 66. L'unité « Oe » est un Oersted (= $10^{-4}$ Tesla). Par exemple, ici, la piste 76 est déposée ou gravée sur une couche en matériau diélectrique reposant directement sur la couche dans laquelle l'électrode 62 est formée. La piste 76 est isolée de l'électrode 62 par l'épaisseur de la couche en matériau diélectrique. Ainsi, la piste 76 est séparée de la couche libre 66 par une distance minimale inférieure à 1 $\mu m$ et, de préférence, inférieure à 400 nm.

L'utilisation du générateur magnétique 50 pour régler la fréquence ou l'amplitude du signal oscillant présente plusieurs avantages.

Par exemple, lorsque le dispositif 6 est faiblement accordable à l'aide de l'intensité du courant polarisé en spin, ce générateur permet de réduire la consommation électrique de l'oscillateur 2 nécessaire pour faire fonctionner les boucles 16, 34 et/ou 44. Pour illustrer cela, les valeurs numériques typiques suivantes sont utilisées : $df_{sdc}/dI = 60$ MHz/mA et $df_{osc}/dH = 10$ MHz/Oe, où H est l'intensité du champ magnétique qui traverse la couche libre 66. La résistance du dispositif 6 entre les bornes 8 et 10 est prise égale à 300 Ω.

Avec ces valeurs, pour faire varier de 10 MHz la fréquence $f_{osc}$, il faut faire varier l'intensité du courant de polarisation de 0,17 mA ce qui correspond à une puissance consommée égale à 8,5 μW $(=300\,\Omega * (0,17\,mA)^2)$.

Pour obtenir la même variation de la fréquence $f_{osc}$ en utilisant le générateur 50, il faut que celui-ci génère une variation de 1 Oe du champ magnétique qui traverse la couche libre 66. Une telle variation de l'intensité du champ magnétique peut être créée à l'aide d'un courant de 0,3 mA circulant dans la piste 76. Ainsi, la même variation de la fréquence $f_{osc}$ en utilisant le générateur 50 consomme uniquement 0,9 μW $(=10\,\Omega * (0,3\,mA)^2)$.

Ainsi, l'utilisation du générateur 50 permet de grandement réduire la consommation électrique des boucles d'asservissement et/ou de rétroaction de l'oscillateur 2. Ceci résulte du fait que l'accordabilité du dispositif 6 en champ, représentée par la dérivée $df_{osc}/dH$, est généralement très supérieure à l'accordabilité en intensité représentée par la dérivée $df_{osc}/dI$ pour un grand nombre de dispositifs magnétorésistifs et tout particulièrement pour ceux faiblement accordables

Ce générateur 50 permet également le réglage de la fréquence ou de l'amplitude du signal s(t) même si la dérivée $df_{osc}/dI$ est très faible ou nulle.

Le fonctionnement de l'oscillateur 2 va maintenant être décrit plus en détail en regard du procédé de la figure 3.

Initialement, lors d'une étape 90, la source 4 de courant est commandée pour générer un courant continu $I_d$ dont l'intensité est strictement inférieure au seuil $I_c$. Dans ces conditions, le dispositif 6 se comporte comme un résonateur.

En parallèle, lors d'une étape 92, l'amplificateur 46 amplifie la partie du signal s(t) captée au niveau de la borne 10 et injecte, en phase, sa copie amplifiée $C_3(t)$ sur la borne 10. La boucle 44 permet ainsi de compenser les pertes du dispositif 6 de manière à obtenir une oscillation entretenue même si l'intensité du courant $I_d$ est strictement inférieure au seuil $I_c$. Puisque l'intensité du courant $I_d$ utilisé est plus faible, le facteur RA de la barrière tunnel du dispositif 6 peut être augmenté de manière à augmenter la sensibilité du dispositif 6 et de l'oscillateur 2. Cela permet de relâcher les contraintes de fabrication du dispositif 6.

Il a été constaté que le facteur de qualité de l'oscillateur formé par la seule combinaison de la boucle 44 avec le dispositif 6 augmente au fur et à mesure que l'intensité du courant $I_d$ augmente. Ainsi, le facteur de qualité peut être réglé en ajustant l'intensité du courant $I_d$. Cela peut être mis à profit pour limiter la consommation de l'oscillateur 2 lorsqu'un facteur de qualité élevé n'est pas nécessaire.

En parallèle, lors d'une étape 94, la boucle 34 asservit l'amplitude $A_{osc}$ des oscillations du signal s(t) sur la valeur $A_{ref}$. Pour cela, lors de l'étape 94, le capteur 36 mesure l'amplitude $A_{osc}$. Ensuite, le comparateur 38 compare l'amplitude $A_{osc}$ avec la valeur $A_{ref}$ et génère le signal de commande $C_2(t)$ propre à réduire l'écart entre l'amplitudes $A_{osc}$ et la valeur $A_{ref}$. Le signal $C_2(t)$ est injecté après avoir été amplifié par l'amplificateur 41 sur la borne 18.

L'amplitude $A_{osc}$ des oscillations du signal s(t) est reliée par une fonction monotone N à la fréquence $f_{osc}$. Ainsi, l'asservissement de l'amplitude $A_{osc}$ sur la valeur $A_{ref}$ asservit la fréquence $f_{osc}$ sur une fréquence de référence correspondant à N(Aref).

Toutefois, la comparaison de l'amplitude $A_{osc}$ et la valeur $A_{ref}$ est réalisée beaucoup plus rapidement que la comparaison des fréquences $f_{osc-r}$ et $f_{ref}$. En effet, pour comparer une amplitude à une valeur, il n'est pas nécessaire de mettre en oeuvre un diviseur de fréquence. Ainsi, la boucle 34 réagit beaucoup plus rapidement que la boucle 16 et permet donc de compenser des fluctuations rapides de la fréquence $f_{osc}$ que la boucle 16 n'est pas capable de compenser. Puisque la boucle d'asservissement 34 est beaucoup plus rapide qu'une boucle d'asservissement en fréquence, le facteur de qualité de l'oscillateur 2 s'en trouve amélioré.

Enfin, en parallèle des étapes 92 et 94, lors d'une étape 96, la boucle 16 verrouille la phase du signal s(t) sur la phase du signal de référence r(t). Pour cela, le diviseur 20 divise la fréquence du signal s(t) pour obtenir le signal s(t)* de fréquence $f_{osc-r}$. Les signaux s(t)* et r(t) sont ensuite comparés par le comparateur 24. Le comparateur 24 génère alors le signal $C_1(t)$ en fonction de l'écart entre les phases des signaux s(t)* et r(t). Ce signal $C_1(t)$ est construit pour réduire cet écart. Il est appliqué après avoir été amplifié par amplificateur 28 sur la borne 18.

Ainsi, la boucle 16 permet de maintenir le signal s(t) en phase avec le signal r(t).

Lors d'une étape 98, les différents signaux de commande générés lors des étapes 92 à 94 et 96 s'ajoutent les uns aux autres et sont injectés sur la même borne 18 de commande. Ces signaux de commande font alors variés l'intensité du champ magnétique proportionnellement à l'intensité des courants électriques générés par les boucles 16, 34 et 44. Cette modification de l'intensité du champ magnétique modifie l'amplitude et la fréquence du signal s(t) généré par le dispositif 6 sur la borne 10. Pour que la sensibilité du dispositif 6 aux variations de l'intensité du champ magnétique soit bonne, le gain des amplificateurs 28 et 41 est réglé pour que l'intensité du courant injecté dans la piste 76 permettent d'obtenir un champ magnétique d'au moins 10 Oe dans la couche libre. En effet, en dessous de cette intensité pour le champ magnétique, les variations de la fréquence $f_{osc}$ sont difficilement perceptibles.

Les étapes 90 à 98 sont réitérées en boucle.

De nombreux autres modes de réalisation de l'oscillateur 2 sont possibles. En particulier, les boucles 16, 34 et 44 peuvent être utilisées indépendamment les unes des autres. Par exemple, la boucle 16 d'asservissement en fréquence peut être omise.

Chacune de ces boucles 16, 34 et 44 peut être raccordée soit à la borne de commande 18 soit à une borne de commande en intensité de la fréquence $f_{osc}$.

Plus précisément, lorsque le dispositif magnétorésitif est fortement accordable à l'aide de l'intensité, c'est-à-dire que la dérivée $df_{osc}/dI$ est supérieure à 1 GHz/mA, les boucles d'asservissement ou de rétroaction sont raccordées à une borne de commande de l'intensité du courant délivré par la source de courant. Un exemple d'un tel mode de réalisation est illustré sur la figure 4. Dans l'oscillateur 100 de la figure 4, la borne 18 est remplacée par une borne 102 de commande de l'intensité du courant $I_d$. Dans l'oscillateur 100, la boucle 16 a également été omise.

La source 4 est remplacée par une source 104 de courant continu dont l'intensité est commandable en fonction du signal injecté sur la borne 102.

Les boucles 34 et 44 sont raccordées à cette borne 102 à la place de la borne 18.

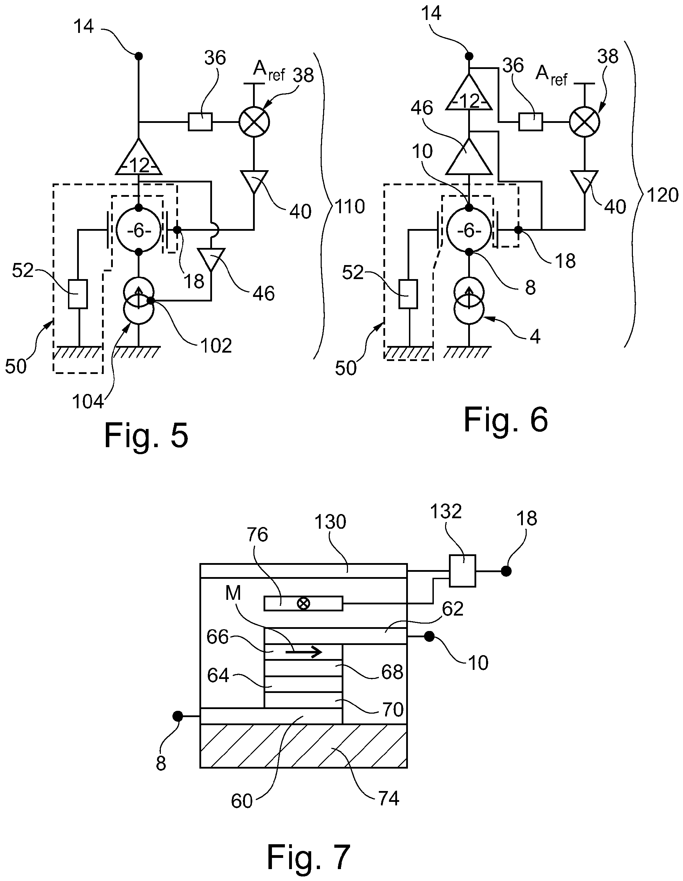

Dans d'autres modes de réalisation, certaines boucles peuvent être raccordées à la borne 18 tandis que d'autres boucles sont raccordées à la borne 102. Un exemple d'un tel mode de réalisation est illustré sur la figure 5. La figure 5 représente un oscillateur 110 dans lequel la boucle de rétroaction est raccordée à la borne 102 de commande de l'intensité de la source 104 tandis que la boucle d'asservissement en amplitude est raccordée à la borne 18 de commande en champ magnétique. Dans ce mode de réalisation, la boucle 16 est également omise.

En variante, il est possible de raccorder simultanément une ou plusieurs des boucles 16, 34 et 44 à la fois à une borne de commande en champ, comme la borne 18, et à une borne de commande en intensité comme la borne 102. Dans ce cas, de préférence, un répartiteur réglable est introduit pour régler la répartition du signal de commande entre ces deux bornes. Ce répartiteur est réglé manuellement ou automatiquement de manière à maximiser la sensibilité du dispositif magnétorésistif au signal de commande envoyé. Ceci permet de s'adapter à tout type d'oscillateur radiofréquence sans avoir à modifier les boucles d'asservissement ou de rétroacation.

L'amplificateur 46 de la boucle de rétroaction peut également être placé entre les bornes 10 et 14 comme illustré sur la figure 6. La figure 6 représente un oscillateur radiofréquence 120. Ce mode de réalisation permet de diminuer le gain de l'amplificateur 12. En effet, l'amplificateur 12 est raccordé en série avec l'amplificateur 46.

De nombreux autres modes de réalisation du dispositif magnétorésistif 6 sont possibles. Par exemple, la direction de plus facile aimantation de la couche libre et/ou de la couche de référence n'est pas forcément contenue dans le plan de la couche. Par exemple, la direction de plus facile aimantation peut être perpendiculaire au plan de la couche.

Des couches additionnelles peuvent être insérées dans l'empilement de couches formant le pilier du dispositif 6. Par exemple, une couche antiferromagnétique peut être insérée entre la couche libre 66 et l'électrode 62.

La couche de référence peut être un antiferromagnétique synthétique pour fixer la direction de son aimantation. Dans ce cas, la couche 70 peut être omise.

Un (ou plusieurs) polariseur peut aussi être utilisé pour réaliser le dispositif magnétorésistif en plus de la couche de référence. Un polariseur est une couche ou un multicouche magnétique dont l'aimantation est en dehors du plan de la couche et, par exemple, perpendiculaire au plan de la couche. Le polariseur permet de polariser en spin le courant qui le traverse. Typiquement, le polariseur est composé de plusieurs sous-couches superposées les unes sur les autres, par exemple une alternance de couches magnétiques et métalliques (par exemple $(Co/Pt)_n$). Ici, le polariseur n'est pas décrit plus en détail. Pour plus d'informations sur les polariseurs, il est possible de se référer à la demande de brevet FR2 817 998. La présence du polariseur permet d'obtenir une précession de l'aimantation de la couche libre en dehors de son plan. Cela permet par exemple de faire fonctionner l'oscillateur en champ nul, c'est-à-dire en absence de champ magnétique extérieur statique. Par exemple, un polariseur est directement déposé sous l'électrode 62.

Les sections transversales des différentes couches formant le dispositif magnérorésistif ne sont pas nécessairement toutes identiques. Par exemple, le dispositif magnétorésistif peut également être réalisé avec une structure d'empilement connue sous le terme de « point-contact ». De telles structures sont décrites dans la demande de brevet FR 2 892 871.

L'espaceur 68 peut être réalisé dans un matériau électriquement conducteur tel que le cuivre (Cu). Les propriétés magnétorésistives du pilier sont alors qualifiées de magnétorésistance géante ou GMR (Giant Magneto Resistance). Dans ce cas, l'épaisseur de l'espaceur 68 est typiquement supérieure à 2 nm. Généralement son épaisseur est comprise entre 2 et 40 nm et, de préférence, égale à 5 nm à $\pm 25$ % près. De plus, typiquement, l'épaisseur de la couche de référence est strictement supérieure à la longueur de diffusion de spin (voir par exemple la demande de brevet FR2892871 pour une définition de ce terme).

Le dispositif 6 peut être remplacé par un assemblage de dispositifs magnétorésistifs raccordés les uns aux autres en série ou en parallèle pour augmenter la puissance du signal oscillant. Dans ce cas, les bornes d'entrée et de sortie de ces différents dispositifs magnétorésistifs sont raccordées, respectivement, à des bornes communes d'entrée et de sortie. Les boucles d'asservissement en amplitude et/ou en fréquence sont raccordées entre ces bornes communes d'entrée et de sortie. De préférence, si une boucle de rétroaction est utilisée, elle est uniquement implantée localement aux bornes de chacun des dispositifs magnétorésistifs. Ainsi, dans un mode de réalisation particulier, chaque dispositif magnétorésistif de l'assemblage comporte sa propre boucle de rétroaction.

La borne de commande en intensité peut être une borne d'entrée d'un sommateur de courant dont une autre borne d'entrée est raccordée à la sortie d'une source non commandable de courant continu. La sortie de ce sommateur sur laquelle est générée la somme des courants est directement raccordée à la borne d'entrée 8 du dispositif 6.

D'autres dispositions de la piste conductrice 76 formant le générateur 50 de champ sont possibles. Par exemple, en variante, la piste conductrice 76 s'étend parallèlement à la couche libre dans le même plan que cette couche. La piste 76 peut également être déposée et/ou gravée en dessous de l'empilement des couches 64, 66 et 68. Par exemple, dans ce dernier cas, la piste 76 est déposée et gravée sur le substrat 74. De plus, il n'est pas nécessaire que les lignes de champ générées par cette piste 76 traversent la couche libre parallèlement à sa direction de plus facile aimantation. Par exemple, dans une variante préférée, les lignes de champs traversent la couche libre avec une direction perpendiculaire à la direction de plus facile aimantation de cette couche libre.

D'autres générateurs de champ magnétique qu'une piste conductrice peuvent aussi être utilisés.

En variante, le générateur 50 génère, en plus du champ magnétique construit à partir des signaux de commande $C_i(t)$, un champ magnétique statique qui règle la fréquence principale d'oscillation $f_{osc}$.

Etant donné qu'il existe une relation N entre l'amplitude $A_{osc}$ et la fréquence $f_{osc}$, il est possible de réaliser un asservissement en fréquence en mesurant directement l'amplitude $A_{osc}$. Par exemple, pour cela, l'amplitude mesurée est convertie à l'aide de la relation prédéterminée N en une fréquence mesurée $N(A_{osc})$ Ensuite, la fréquence $N(A_{osc})$ est comparée à une fréquence de référence $f_{ref}$. Un comparateur génère alors un signal de commande fonction de l'écart entre ces fréquences $N(A_{osc})$ et $f_{ref}$ permettant de réduire cet écart. Ce signal de commande est alors injecté sur la borne de commande 18 ou 102.

En variante, la source 4 génère un courant continu $I_d$ dont l'intensité est supérieure ou égale au seuil $I_c$. Dans ce cas, la boucle 44 peut être omise. Toutefois, elle peut également être conservée pour améliorer le facteur de qualité de l'oscillateur 2.

Dans une autre variante, il est possible d'intégrer un déphaseur dans la boucle 44. Ce déphaseur a alors pour fonction de maintenir le signal $C_3(t)$ injecté sur la borne 18 en phase avec le signal s(t).

Les caractéristiques des revendications dépendantes peuvent être mises en oeuvre indépendamment des caractéristiques des revendications indépendantes. Par exemple, l'utilisation de la borne 18 du générateur 50 de champ magnétique pour boucler les boucles 16, 34 ou 44 peut être mis en oeuvre indépendamment de l'utilisation de la boucle 44 de rétroaction comportant l'amplificateur 46 équipé :

- d'une entrée raccordée à la borne 10 de sortie de manière à amplifier la partie du signal oscillant captée au niveau de la borne de sortie, et
- d'une sortie raccordée à la borne 18 ou 102 de commande de manière à injecter sur cette borne de commande la partie amplifiée du signal oscillant en phase avec le signal oscillant généré sur la borne de sortie.

## Revendications

1. Oscillateur radiofréquence intégrant :

    - un dispositif magnétorésistif (6) au sein duquel circule un courant électrique polarisé en spin pour générer un signal oscillant à une fréquence d'oscillation sur une borne (10) de sortie, ce dispositif comprenant un empilement d'au moins :

        • une première couche magnétique (64), dite « couche de référence », apte à polariser en spin le courant électrique et dont l'aimantation est de direction fixe,
        • une second couche magnétique (66), dite « couche libre », dont l'aimantation peut osciller lorsqu'elle est traversée par le courant polarisé en spin, et
        • une couche non magnétique (68), dite « espaceur », interposée entre les deux couches précédentes pour former une jonction tunnel ou une vanne de spin,

    - une source (4; 104) de courant pour faire circuler un courant d'électrons dans lesdites couches perpendiculairement à celles-ci, et
    - une borne (18; 102) de commande de la fréquence ou de l'amplitude du signal oscillant, ladite borne de commande agissant sur l'intensité de la source de courant ou sur une caractéristique d'un champ magnétique généré propre à modifier la fréquence d'oscillation du dispositif magnétorésistif (6), ce champ magnétique étant généré par un générateur (50) qui est agencé par rapport au dispositif (6) de manière à ce que les lignes du champ magnétique qu'il génère traversent la couche libre du dispositif (6), et
    - une boucle (44) de rétroaction raccordée entre la borne de sortie et la borne de commande,

**caractérisé en ce que** la boucle (44) de rétroaction comporte un amplificateur (46) équipé :

- d'une entrée raccordée à la borne (10) de sortie de manière à amplifier la partie du signal oscillant captée au niveau de la borne de sortie, et
- d'une sortie raccordée à la borne (18 ; 102) de commande de manière à injecter sur cette borne de commande la partie amplifiée du signal oscillant avec un déphasage par rapport au signal oscillant généré sur la borne de sortie inférieur à $\pi/20$ rad.

2. Oscillateur selon la revendication 1, dans lequel la source (4 ; 104) de courant est uniquement apte à générer un courant continu dont l'intensité est inférieure à un seuil au-delà duquel une précession entretenue de l'aimantation de la couche libre apparaît.

3. Oscillateur selon l'une quelconque des revendications précédentes, dans lequel le gain de l'amplificateur (46) est suffisant pour compenser les pertes du dispositif magnétorésistif.

4. Oscillateur selon l'une quelconque des revendications précédentes, dans lequel l'entrée et la sortie de l'amplificateur (46) sont directement raccordées, respectivement, à la borne de sortie du dispositif magnétorésistif et à la borne de commande.

5. Oscillateur selon l'une quelconque des revendications précédentes, dans lequel l'espaceur (68) est un matériau électriquement isolant agencé de manière à créer une jonction tunnel dont le facteur RA est supérieur à 2 ou 5 $\Omega\mu\text{m}^2$, le facteur RA étant le produit de la résistance de la barrière tunnel, formée par l'espaceur (68), avec son aire.

6. Oscillateur selon l'une quelconque des revendications précédentes, dans lequel l'oscillateur comprend une source (104) de courant continu, raccordée à une borne d'entrée du dispositif magnétorésistif, dont l'intensité est commandable en fonction d'un signal injecté sur la borne (102) de commande.

7. Procédé de génération d'un signal oscillant à une fréquence d'oscillation, ce procédé comportant la fourniture d'un oscillateur conforme à l'une quelconque des revendications précédentes, **caractérisé en ce que** le procédé comprend l'amplification (92) de la partie du signal oscillant captée au niveau de la borne de sortie et l'injection (92) de cette partie amplifiée du signal oscillant sur la borne de commande avec un déphasage par rapport au signal oscillant généré sur la borne de sortie inférieur à $\pi/20$ rad.

8. Procédé selon la revendication 7, dans lequel le procédé comprend la commande (90) de la source de courant pour générer un courant continu dont l'intensité est strictement inférieure à un seuil au-delà duquel une précession entretenue de l'aimantation de la couche libre apparaît.

**Patentansprüche**

1. Hochfrequenzoszillator, in den integriert sind:

- eine magnetoresistive Vorrichtung (6), in welcher ein spinpolarisierter elektrischer Strom fließt, um an einer Ausgangsklemme (10) ein mit einer Schwingungsfrequenz oszillierendes Signal zu erzeugen, wobei diese Vorrichtung einen Stapel aus wenigstens Folgendem umfasst:

• einer ersten magnetischen Schicht (64), "Referenzschicht" genannt, die geeignet ist, den elektrischen Strom zu spinpolarisieren, und deren Magnetisierung eine feste Richtung aufweist,
• einer zweiten magnetischen Schicht (66), "freie Schicht" genannt, deren Magnetisierung oszillieren kann, wenn sie von dem spinpolarisierten Strom durchflossen wird, und
• einer nicht-magnetischen Schicht (68), "Abstandsschicht" genannt, die zwischen den zwei vorhergehenden Schichten angeordnet ist, um einen Tunnelübergang oder ein Spinventil zu bilden,

- eine Stromquelle (4; 104), um einen Strom von Elektronen in den Schichten senkrecht zu diesen fließen zu lassen, und
- eine Klemme (18; 102) zur Steuerung der Frequenz oder der Amplitude des oszillierenden Signals, wobei diese Steuerklemme auf die Stärke der Stromquelle oder auf ein Merkmal eines erzeugten Magnetfeldes einwirkt, das geeignet ist, die die Schwingungsfrequenz der magnetoresistiven Vorrichtung (6) zu ändern, wobei dieses Magnetfeld von einem Generator (50) erzeugt wird, welcher bezüglich der Vorrichtung (6) derart angeordnet ist, dass die Linien des Magnetfeldes, welches er erzeugt, die freie Schicht der Vorrichtung (6) durchqueren, und
- eine Rückkopplungsschleife (44), die zwischen die Ausgangsklemme und die Steuerklemme geschaltet ist,

**dadurch gekennzeichnet, dass** die Rückkopplungsschleife (44) einen Verstärker (46) aufweist, der ausgestattet ist:

- mit einem Eingang, der an die Ausgangsklemme (10) angeschlossen ist, um den Teil des oszillierenden Signals zu verstärken, der an der Ausgangsklemme empfangen wird, und

- mit einem Ausgang, der an die Steuerklemme (18; 102) angeschlossen ist, um an dieser Steuerklemme den verstärkten Teil des oszillierenden Signals mit einer Phasendifferenz zu dem an der Ausgangsklemme erzeugten oszillierenden Signal einzuspeisen, die kleiner als π/20 rad ist.

2. Oszillator nach Anspruch 1, wobei die Stromquelle (4; 104) ausschließlich geeignet ist, einen Gleichstrom zu erzeugen, dessen Stromstärke kleiner als ein Schwellenwert ist, oberhalb dessen eine anhaltende Präzession der Magnetisierung der freien Schicht stattfindet.

3. Oszillator nach einem der vorhergehenden Ansprüche, wobei der Verstärkungsfaktor des Verstärkers (46) ausreichend ist, um die Verluste der magnetoresistiven Vorrichtung auszugleichen.

4. Oszillator nach einem der vorhergehenden Ansprüche, wobei der Eingang und der Ausgang des Verstärkers (46) direkt an die Ausgangsklemme der magnetoresistiven Vorrichtung bzw. an die Steuerklemme angeschlossen sind.

5. Oszillator nach einem der vorhergehenden Ansprüche, wobei die Abstandsschicht (68) ein elektrisch isolierendes Material ist, das dafür ausgelegt ist, einen Tunnelübergang zu erzeugen, dessen Faktor RA größer als 2 oder 5 $\Omega\mu m^2$ ist, wobei der Faktor RA das Produkt des Widerstands der Tunnelbarriere, die von der Abstandsschicht (68) gebildet wird, mit ihrer Fläche ist.

6. Oszillator nach einem der vorhergehenden Ansprüche, wobei der Oszillator eine Gleichstromquelle (104) umfasst, die an eine Eingangsklemme der magnetoresistiven Vorrichtung angeschlossen ist und deren Stromstärke in Abhängigkeit von einem Signal steuerbar ist, das an der Steuerklemme (102) eingespeist wird.

7. Verfahren zur Erzeugung eines mit einer Schwingungsfrequenz oszillierenden Signals, wobei dieses Verfahren die Bereitstellung eines Oszillators nach einem der vorhergehenden Ansprüche umfasst, **dadurch gekennzeichnet, dass** das Verfahren die Verstärkung (92) des Teils des oszillierenden Signals, der an der Ausgangsklemme empfangen wird, und die Einspeisung (92) dieses verstärkten Teils des oszillierenden Signals an der Steuerklemme mit einer Phasendifferenz zu dem an der Ausgangsklemme erzeugten oszillierenden Signal, die kleiner als π/20 rad ist, umfasst.

8. Verfahren nach Anspruch 7, wobei das Verfahren die Steuerung (90) der Stromquelle umfasst, um einen Gleichstrom zu erzeugen, dessen Stromstärke streng kleiner als ein Schwellenwert ist, oberhalb dessen eine anhaltende Präzession der Magnetisierung der freien Schicht stattfindet.

**Claims**

1. Radiofrequency oscillator incorporating:

- a magnetoresistive device (6) through which a spin-polarized electric current flows in order to generate an oscillating signal at a frequency of oscillation on an output terminal (10), this device comprising a stack of at least:

• a first magnetic layer (64), referred to as the "reference layer", capable of spin-polarizing the electric current and the magnetization of which is of fixed direction;
• a second magnetic layer (66), referred to as the "free layer", the magnetization of which may oscillate when the spin-polarized current flows therethrough; and
• a non-magnetic layer (68), referred to as the "spacer", interposed between the two preceding layers in order to form a tunnel junction or spin valve;

- a current source (4; 104) for causing a current of electrons to flow through said layers perpendicularly to the latter; and
- a terminal (18; 102) for controlling the frequency or the amplitude of the oscillating signal, said control terminal acting on the intensity of the current source or on a characteristic of a generated magnetic field specifically for modifying the frequency of oscillation of the magnetoresistive device (6), this magnetic field being generated by a generator (50) that is arranged with respect to the device (6) so that the field lines of the magnetic field generated thereby pass through the free layer of the device (6); and
- a feedback loop (44) connected between the output terminal and the control terminal,

**characterized in that** the feedback loop (44) includes an amplifier (46) provided with:

- an input that is connected to the output terminal (10) so as to amplify the portion of the oscillating signal detected at the output terminal; and
- an output that is connected to the control terminal (18; 102) so as to inject, into this control terminal, the amplified portion of the oscillating signal with a phase shift with respect to the oscillating signal generated on the output terminal that is smaller than $\pi/20$ rad.

2.  Oscillator according to Claim 1, in which the current source (4; 104) is solely capable of generating a DC current, the intensity of which is lower than a threshold beyond which a sustained precession of the magnetization of the free layer occurs.

3.  Oscillator according to either of the preceding claims, in which the gain of the amplifier (46) is sufficient to compensate for the losses from the magnetoresistive device.

4.  Oscillator according to any one of the preceding claims, in which the input and the output of the amplifier (46) are directly connected to the output terminal of the magnetoresistive device and to the control terminal, respectively.

5.  Oscillator according to any one of the preceding claims, in which the spacer (68) is an electrically insulating material that is arranged so as to create a tunnel junction, the RA factor of which is higher than 2 or 5 $\Omega\mu m^2$, the RA factor being the product of the resistance of the tunnel barrier, formed by the spacer (68), and the area thereof.

6.  Oscillator according to any one of the preceding claims, in which the oscillator comprises a DC current source (104), which source is connected to an input terminal of the magnetoresistive device, the intensity of which can be controlled according to a signal injected into the control terminal (102).

7.  Method for generating an oscillating signal at a frequency of oscillation, this method including the provision of an oscillator in accordance with any one of the preceding claims,
    **characterized in that** the method comprises the amplification (92) of the portion of the oscillating signal detected at the output terminal and the injection (92) of this amplified portion of the oscillating signal into the control terminal with a phase shift with respect to the oscillating signal generated on the output terminal that is smaller than $\pi/20$ rad.

8.  Method according to Claim 7, in which the method comprises the control (90) of the current source in order to generate a DC current, the intensity of which is strictly lower than a threshold beyond which a sustained precession of the magnetization of the free layer occurs.

Fig. 1

Fig. 2

Fig. 4

Fig. 3

Fig. 5

Fig. 6

Fig. 7

**EP 2 543 134 B1**

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5695864 A
- FR 2892871
- JP 2008128711 A
- EP 1860769 A1
- US 6566872 B1
- FR 0957888
- FR 2817998

**Littérature non-brevet citée dans la description**

- **BAIBICH, M. ; BROTO, J.M. ; FERT, A. ; NGUYEN VAN DAU, F. ; PETROFF, F. ; ETIENNE, P. ; CREUZET, G. ; FRIEDERCH, A. ; CHAZELAS, J.** Giant magnetoresistance of (001)Fe/(001)Cr magnetic superlattices. *Phys.Rev.Lett.,* 1988, vol. 61, 2472
- **MOODERA, JS. ; KINDER, LR. ; WONG, TM. ; MESERVEY,R.** Large magnetoresistance at room temperature in ferromagnetic thin film tunnel junctions. *Phys.Rev.Lett,* 1995, vol. 74, 3273-6
- **KATINE, J.A. ; ALBERT, F.J. ; BUHRMAN, R.A. ; MYERS, E.B. ; RALPH, D.C.** Current-Driven Magnetization Reversai and Spin-Wave Excitations in Co /Cu /Co Pillars. *Phys.Rev.Lett.,* 2000, vol. 84, 3149
- **KISELEV, S.I. ; SANKEY, J.C. ; KRIVOROTOV, LN. ; EMLEY, N.C. ; SCHOELKOPF, R.J. ; BUHRMAN, R.A. ; RALPH, D.C.** Microwave oscillations of a nanomagnet driven by a spin-polarized current. *Nature,* 2003, vol. 425, 380

**15**